# EUROPEAN PATENT SPECIFICATION

(11) **EP 4 288 506 B1**
(45) Date of publication and mention of the grant of the patent: **02.04.2025**
(21) Application number: 22704891.5
(22) Date of filing: 03.02.2022
(51) Int. Cl.: C09K 11/02

(54) **A METHOD TO PREPARE POCKETS OF ENCAPSULATED MATERIAL COMPRISING A CORE SURROUNDED BY AN ENCAPSULATION**
VERFAHREN ZUR HERSTELLUNG VON TASCHEN AUS EINGEKAPSELTEM MATERIAL MIT EINEM VON EINER EINKAPSELUNG UMGEBENEN KERN
PROCÉDÉ DE PRÉPARATION DE POCHES DE MATÉRIAU ENCAPSULÉ COMPRENANT UN NOYAU ENTOURÉ D'UNE ENCAPSULATION

(30) Priority: 05.02.2021 EP 21155510
(43) Date of publication of application: 13.12.2023
(73) Proprietor: Universiteit Gent, 9000 Gent (BE)
(72) Inventor: HENS, Zeger, 9000 Gent (BE); AUBERT, Tangi, 34070 Montpellier (FR)
(86) International application number: PCT/EP2022/052565
(87) International publication number: WO 2022/167516

(56) References cited:
- US-A1- 2012 068 209
- US-A1- 2015 048 403

## Description

### Field of the invention

The present invention relates to a method to prepare at least one pocket, preferably a plurality of pockets, comprising encapsulated material. Such pockets comprise core material (the encapsulated material) surrounded by an encapsulation comprising barrier material. The invention also relates to a pocket or a plurality of pockets comprising encapsulated material obtained by such method.

### Background art

Many materials, in particular nanomaterials are sensitive material and need to be protected from their surroundings to avoid degradation. Semiconductor nanocrystals or quantum dots (QDs) in particular suffer from chemical degradation when exposed to oxygen or water vapor. Chemical degradation of quantum dots should be avoided as it inevitably results in a decrease of emission efficiency.

Quantum dots feature a spectrally narrow and tunable photoluminescence, which makes them particularly interesting as photoluminescent color convertor for example for display, lighting and projection applications. However, the sensitivity of quantum dots has been one of the main critical and long lasting limitations for the use of quantum dots in most applications. In lighting and display applications, this issue is even stronger because the emission color and intensity need to remain unchanged during continuous operation for periods of time that extend over thousands of hours. The quantum dots can be implemented as so-called remote phosphors, whereby the quantum dots are well separated from the primary blue LEDs or they can be deposited directly on the blue LED chip (on-chip approach). The on-chip approach imply local heating (ca. 100 °C) of the quantum dots. Such heating may further accelerate quantum dot degradation.

The exact mechanism for quantum dot degradation for example by oxygen and/or water vapor still remains to be elucidated and important research efforts are dedicated worldwide into making quantum dots more resistant. Nevertheless, it is well established that, for the large scale and reliable deployment of quantum dots, gas diffusion barriers need to be implemented in some sort in quantum dots based devices.

To protect quantum dots from oxygen and water vapor, quantum dots are typically encapsulated. Currently, there are two main strategies for the encapsulation of such materials: the thin film encapsulation (TFE) approach and the bead approach. In both cases, the quantum dots are typically embedded in a polymer resin. The resin is casted and cured as a thin film (TFE) or as micro-sized particles (beads). The barrier properties are implemented by applying multiple layers of alternating inorganic material (for example SiO₂, TiO₂ or Al₂O₃) and organic (polymer) material onto the films or beads. This multilayer barrier approach is designed to circumvent the inevitable presence of defects in the inorganic layer, by creating tortuous pathways for gas diffusion. However, the application of multilayers typically requires a variety of successive deposition techniques, in particular vacuum deposition techniques such as atomic layer deposition (ALD), chemical vapor deposition (CVD) or sputtering. Consequently, the application of multilayers results in a complex and expensive fabrication process. Furthermore, materials encapsulated using the TFE approach may suffer from so-called edge ingress effects to the lateral sides. In the bead approach, although the quantum dots are protected isotropically by the multilayer barrier, the physical deposition of an inorganic barrier layer all around a microparticle remains technically difficult. Furthermore, the beads need to be blended again with another resin to allow further processing. Examples of prior art processes are disclosed in US2012/068209 A1 which discloses a semiconductor light emitting device comprising pockets comprising phosphor-containing material and in US2015/048403 A1 which discloses a method for making multiple hermetically sealed optical components, comprising the creation of pockets and the pockets as such.

Therefore, it is clear that there is a need to provide nanomaterials that are well protected from degradation by oxygen and water vapor. In particular, there is a need to provide quantum dots that are well protected from degradation by oxygen and water vapor.

As nanomaterials such as for example quantum dots are sensitive materials, it is clear that any processing of nanomaterials such as quantum dots needs to take into account the sensitive nature of the nanomaterials. The processing of such nanomaterial may for instance not afford any treatment that would imply the use of elevated temperatures. In addition, the processing of nanomaterials is preferably compatible with large-scale fabrication.

### Summary of the invention

It is an object of the present invention to provide a method to prepare pockets comprising encapsulated material avoiding the drawbacks of the prior art. This method is in particular suitable to prepare pockets comprising quantum dots as encapsulated material.

It is another object of the present invention to provide a method to prepare pockets comprising encapsulated material whereby the encapsulated material is not suffering from edge ingress.

It is a further object of the present invention to provide a method to prepare pockets comprising encapsulated material not requiring successive formation of a multilayered encapsulation using different techniques.

It is a further object of the present invention to provide a method to prepare an array of pockets comprising encapsulated material allowing to combine different types of pockets, for example pockets comprising different encapsulated material in one array.

It is a further object of the present invention to provide a method to prepare pockets comprising encapsulated material allowing to obtain a high versatility of shapes in two or three dimensions.

It is another object of the present invention to provide a method allowing to prepare large scale as well as miniaturized fabrication of pockets of encapsulated material.

It is a further object of the present invention to provide pockets of encapsulated material and to provide an array of pockets of encapsulated material.

Furthermore, it is an object of the present invention to provide pockets comprising encapsulated material comprising quantum dots and to provide an array of pockets comprising encapsulated material comprising quantum dots.

It is a further object of the present invention to provide a device comprising pockets of encapsulated material, for example comprising quantum dots.

It is still a further object of the present invention to provide a process to transfer pockets of encapsulated material, in particular a process to transfer pockets comprising quantum dots.

According to a first aspect of the present invention a method to prepare at least one pocket, preferably a plurality of pockets, comprising encapsulated material is provided. Such at least one pocket of encapsulated material comprises core material surrounded, preferably fully surrounded, by an encapsulation comprising barrier material. The method according to the present invention comprises the steps of
a. forming one or more bases B of barrier material on a substrate by
   a1. applying barrier material b comprising a resin, for example a layer of barrier material b, on the substrate;
   a2. locally curing the barrier material b to form one base B or a plurality of bases B of cured barrier material b, each base B being spatially distinguished from another base B and each base B covering an area A_{B} of the substrate;
   a3. removing uncured barrier material b;
b. forming core material c on top of at least part of the bases B by,
   b1. applying core material c comprising a resin and at least one photoemissive particle or photoemissive compound, for example a layer of core material c (comprising a resin and at least one photoemissive particle or photoemissive compound), on the substrate obtained from step a.;
   b2. locally curing the core material c to form one core deposit or a plurality of core deposits of cured core material c, with each core deposit of cured core material c being deposited on top of a base B and none of the core deposits of cured core material c extending beyond the area A_{B};
   b3. removing uncured core material c;
c. forming one or more lids L of barrier material on the substrate provided with the one or more bases B and provided with the core material by
   c1. applying barrier material I comprising a resin, for example a layer of barrier material I, on the substrate obtained from step b.;
   c2. locally curing the barrier material I to form a lid L of cured barrier material I on top of each base B provided with core material c, each lid L being spatially distinguished from another lid L, each base B provided with core material c and the lid L formed on top of his base B forming a pocket, whereby said pocket is fully encapsulating the core material c provided on the base B of said pocket.
   c3. removing uncured barrier material I.

The combination of all core material c deposited on a base B is referred to as core C. A core C can be formed by applying core material c, curing the core material c and removing the uncured core material c, i.e. by executing steps b1 to b3, once. Alternatively, a core C can be formed by executing steps b1 to b3 more than once, whereby either the same core material c or different core material c is applied in the different iterations of steps b1 to b3.

In a particular method, first core material c1 is formed on a base B by applying first core material c1, curing the first core material c1 and removing the uncured first core material c1, i.e. by executing steps b1 to b3. Subsequently, second core material c2 is formed on the base B by applying second core material c2, curing the second core material c2 and removing the uncured second core material c2, i.e. by executing steps b1 to b3 a second time. Possibly, barrier material is applied, for example on the base B next to deposits of first core material c1 between the forming of the second core material and the forming of the second core material.

It is clear that a core C may comprise more than two different types of core material, for example a first core material c1, a second core material c2 and any further core material cn.

The application of barrier material b (step a1), the application of core material c (step b1) and/or the application of barrier material I can be done by any technique known in the art. Preferred techniques to apply the barrier material b, the core material c and/or the barrier material I comprise extrusion, doctor blading, jetting and roll-to-roll application techniques.

The curing of the barrier material b (step a2), the curing of the core material c (step b2) and/or the curing of the barrier material I (step c2) may comprise any type of curing known in the art. Preferably, the curing of the barrier material b, the curing of the core material c and/or the curing of the barrier material I comprises photocuring. Photocuring comprises hardening of material induced by being exposed to a light source, typically in the UV or visible.

Preferably the application and locally curing of the barrier material b, the application and locally curing of the core material c and/or the application and locally curing of the barrier material I comprises photolithography using a physical mask or digital light modulation. Examples of photolithography using digital light modulation comprise digital light processing (DLP), laser-based stereolithography (SLA), liquid crystal display (LCD) masking, liquid crystal display (LCD) projecting and multiphoton lithography (for example two photon lithography (TPL)).

The barrier material b, the core material c and/or the barrier material I comprise a resin and more preferably a photocurable resin. A resin is a solid or viscous substance that is typically convertible into a polymer. Usually, a resin is a mixture of organic compounds. A photocurable resin is a resin that cures/solidifies upon exposure of light.

Preferred (photocurable) resins comprise photopolymers comprising thiol-ene, acrylate, epoxy, urethane or vinyl based resins or mixture thereof.

The barrier material b, the core material c and/or the barrier material I may further comprise at least one photoinitiator and/or at least one filler and/or at least one dye.

Preferred photoinitiators comprise 2,2-dimethoxy-2-phenylacetophenone (DMPA), diphenyl(2,4,6-trimethylbenzoyl)phosphine oxide (TPO), photoinitiator or photoinitiator blends from the Irgacure^{®} or Darocur^{®} product lines.

As fillers inorganic fillers, 1D fillers, 2D fillers or a combination thereof can be considered. Inorganic fillers comprise for example oxide particles such as SiO₂, TiO₂, or Al₂O₃ particles. 1D fillers comprise for example cellulose based materials, for example cellulose nanofibrils. 2D fillers comprise for example nanoclay such as montmorillonite nanoclay.

Preferred dyes comprise organic dyes with photocatalytic degradation such as Reactive Orange 16 or Orange Orasol G.

Preferably, both the barrier material b and the barrier material I have water vapour and oxygen barrier properties.

The barrier material b and the barrier material I comprise for example a photocurable resin, at least one photoinitiator and at least one 1D filler as for example cellulose nanofibrils and/or at least one 2D filler as for example nanoclay.

The barrier material b and the barrier material I may comprise the same material or may comprise a different material.

In preferred embodiments, the barrier material b and the barrier material I of a pocket of encapsulated material comprise the same material. Such embodiments allow to form pockets of encapsulated material wherein the core material is surrounded by an encapsulation layer comprising one material.

The core material c comprises a resin and at least one photoemissive particle or photoemissive compound, for example at least one photoluminescent particle or at least one photoluminescent compound. Preferably, the core comprises a plurality of photoemissive particles or photoemissive compounds. The barrier material b and the barrier material I comprises preferably no photoemissive particles or compounds.

Examples of photoemissive particles or photoemissive compounds comprise semiconductor nanocrystals such as quantum dots, organic dyes, inorganic phosphors, metal clusters, carbon dots, doped nanocrystals such as lanthanide doped nanocrystals or combinations thereof.

Particularly preferred photoluminescent particles comprise quantum dots.

The core material c comprises for example a photocurable resin, at least one photoinitiator and quantum dots.

According to the present invention, the pockets of encapsulated material are preferably formed on a substrate. The substrate may comprise a flexible or rigid substrate. Preferred substrates comprise Si wafers, glass substrates, metal substrates or polymer substrates.

In case a plurality of bases B is applied on the substrate in step a., the different bases B applied on the substrate may have the same size and/or the same shape and/or may cover the same area A_{B}. Alternatively, different types of bases are applied on the substrate, for example a first type of bases B1 having a first size and/or having a first shape and/or covering a first area A_{B1} of the substrate, a second type of bases B2 having a second size and/or having a second shape and/or covering a second area A_{B1} of the substrate and optionally further types of bases Bf having a further size and/or having a further shape and/or covering a further area A_{Bf} of the substrate.

In step b., core material is applied on at least part of the bases B. Preferably, core material is applied on all bases B. Alternatively, only part of the bases B are provided with core material.

First core material c, for example a layer of core material c, is applied on the substrate obtained from step a., i.e. on the substrate provided with one or more bases B. Subsequently, this core material is locally cured to form one core deposit or a plurality of core deposits of cured core material c. The uncured core material is then removed.

A core deposit of cured core material deposited on a base B is not extending beyond the area A_{B}, i.e. the area of the substrate covered by a base.

Preferably, the top surface of a base B is not completely covered with core material c. Most preferably, the outer circumference of the top surface of a base B is not covered with core material. In other cases, the top surface of the core material deposited on a base B is fully covered by core material. In such cases, the core material covers an area A_{C} equal to area A_{B}.

In step c., one or more lids L of barrier material is formed on top of at least part of the bases b. First barrier material I, for example a layer of barrier material I, is applied on the substrate provided with one or more bases B and provided with core material, i.e. on the substrate obtained from step b. Subsequently, the barrier material I is locally cured to form a lid L of cured barrier material on top of each base provided with core material c. Then the uncured barrier material I is removed. Each base B provided with core material c and the lid L formed on top of this base B forms a pocket. Such pockets thus comprises the barrier material b of the base B and the barrier material of the lid L and is fully encapsulating the core material c provided on the base B of this pocket.

For each pocket, the lid L covers the top of the core material as well as the lateral edges of the core material deposited on the base B of this pocket. In this way, the core material deposited on a base B is fully encapsulated by a combination of the barrier material of the base B and the barrier material of the lid L. Consequently, the core material and in particular the photoemissive particle(s) or compound(s) present in the core material are fully encapsulated by barrier material. The core material and in particular the photoemissive particle(s) or compound(s) do not suffer from edge ingress.

A lid deposit of cured barrier material I or the lid L of a pocket may extend beyond the area A_{B}, i.e. the area of the substrate covered by the base B. The area A_{L} of the substrate covered by a lid L can thus be larger than the area A_{B}.

In other embodiments, the area A_{L} is equal to the area A_{B} (and not extending beyond the area A_{B}).

A base B may be formed by applying and curing one layer of base material or by iterating the application of a layer of barrier material and curing of such barrier material a number of times. In such case step a. of the above described method to prepare a pocket of encapsulated material comprises for example n iteration steps of steps a1' to a3', with n being at least 2 and with a1' to a3' comprising the steps of
a1'. applying for each iteration step i, with i ranging from 1 to n, a layer of barrier material bᵢ on the substrate or on the substrate provided with barrier material obtained from a previous iteration step of step a., whereby for each iteration step i higher than 1 the barrier material bᵢ comprises the same or a different barrier material than the barrier material used in a previous iteration step of step a.;
a2'. locally curing for each iteration step i, with i ranging from 1 to n, the barrier material bᵢ to form one base deposit or a plurality of base deposits of cured barrier material bᵢ, with each base deposit of cured barrier material bᵢ contacting the substrate or contacting a deposit of cured barrier material obtained in a previous iteration step of step a. to form after iteration step n a base B or a plurality of bases B, each base B being spatially distinguished from another base B and each base B covering an area A_{B} of the substrate;
a3'. removing for each iteration step i, with i ranging from 1 to n, uncured barrier material bᵢ.

The number of iteration steps n is in principle not limited. The number of iteration steps n is for example 2, 3, 4, 5 or 6.

It is clear that a base B may comprise one base deposit of cured barrier material or a plurality of base deposits of cured barrier material for example a plurality of deposits deposited next to and/or on top of each other.

By iterating step a. as described above, a high variety of bases B and/or a high variety of combinations of bases B can be obtained. It is for example possible to provide a plurality of bases B on a substrate whereby the bases B may comprise the same barrier material or whereby the bases B or some of the bases B may comprise a different barrier material. It is for example possible to provide a first type of base B comprising a first barrier material, a second type of base B comprising a second barrier material and optionally one or more further types of bases comprising a further barrier material. Furthermore, it is possible to provide a base B or a plurality of bases B whereby each base B comprises one type of barrier material or comprises different types of barrier materials. A base B may for example comprise a first layer comprising a first barrier material, a second layer comprising a second barrier material and optional one or more further layers comprising a further barrier material. Additionally, a base B may comprise deposits of cured barrier material next to each other. Such deposits may comprise the same barrier material or may comprise different barrier materials. A base may for example comprise deposits of cured first barrier material, deposits of cured second barrier material and optionally deposits of cured further barrier material together forming one base B.

Also the core material deposited on top of one or more bases B and/or a lid L may be formed by iterating the application of a layer of core material, respectively barrier material and curing of such core material, respectively barrier material a number of times.

In case the core material deposited on a base B is formed by iterating the application and curing of core material a number of times, step b. of the above described method to prepare a pocket of encapsulated material comprises for example m iteration steps of steps b1' to b3', with m being at least 2 and with b1' to b3' comprising the steps of
b1'. applying for each iteration step i, with i ranging from 1 to m, a layer of core material cᵢ on the substrate obtained from step a. or on the substrate obtained from a previous iteration step of step b., whereby for each iteration step i higher than 1 the core material cᵢ comprises the same or a different core material than the core material used in a previous iteration step of step b.;
b2'. locally curing for each iteration step i, with i ranging from 1 to m, the core material cᵢ to form one core deposit or a plurality of core deposits of cured core material cᵢ, with each core deposit of cured core material cᵢ contacting a base B or contacting a deposit of cured core material obtained in a previous iteration step of step b. and none of said core deposits of cured core material extending beyond the area A_{B};
b3'. removing for each iteration step i , with i ranging from 1 to m, uncured core material Cᵢ.

The number of iteration steps m is in principle not limited. The number of iteration steps m is for example 2, 3, 4 , 5 or 6.

It is clear that the core material deposited on a base B may comprise one core deposit of cured core material or a plurality of base deposits of cured core material for example deposited next to and/or on top of each other.

By iterating step b. as described above, a high flexibility to deposit core material and/or to deposit combinations of core materials can be obtained. It is for example possible to apply on all bases B the same core material, or it is possible to apply different core materials on different bases B. It is for example possible to apply a first type of core material on particular bases B, a second type of core material on other bases B and optionally a further type of core material on still further bases B. In a preferred method a first type of core material comprising a first type of quantum dots, for example green quantum dots is applied on particular bases B and a second type of core material comprising a second type of quantum dots, for example red quantum dots is applied on other bases B.

Furthermore, it is possible that a base B is provided with one type of core material or with different types of core material. A base B may for example comprise a first layer comprising a first core material, a second layer comprising a second core material and optional one or more further layers comprising a further core material. In a preferred method a first type of core material comprising a first type of quantum dots, for example green quantum dots and a second type of core material comprising a second type of quantum dots, for example red quantum dots is applied on a base B.

Additionally, a base B may be provided with deposits of cured core material next to each other. Such deposits may comprise the same core material or may comprise different core materials. A base may for example be provided with deposits of cured first core material, deposits of cured second core material and optionally deposits of cured further core material. In a preferred method a base B is provided with deposits of cured first type of core material comprising a first type of quantum dots, for example green quantum dots and provided with deposits of cured second type of core material comprising a second type of quantum dots, for example red quantum dots.

In case one or more lids L is formed by iterating the application and curing of barrier material a number of times, step c. of the above described method to prepare a pocket of encapsulated material comprises for example p iteration steps of steps c1' to c3', with p being at least 2 and with c1' to c3' comprising the steps of
c1'. applying for each iteration step i, with i ranging from 1 to p, a layer of barrier material Iᵢ on the substrate obtained from method step b. or on the substrate obtained from a previous iteration step of step c., whereby for each iteration step i higher than 1 the barrier material Iᵢ comprises the same or a different barrier material than the barrier material used in a previous iteration step of step c.;
c2. locally curing for each iteration step i, with i ranging from 1 to m, the barrier material Iᵢ to form one lid deposit or a plurality of lid deposits of cured barrier material Iᵢ in such a way to form after iteration step p for each base B provided with core material a lid L, each lid L being spatially distinguished from another lid L, whereby each base B provided with core material c and the lid L provided on this base B form a pocket whereby all core material provided on this base B is fully encapsulated by a combination of the base B and the lid L of this pocket;
c3. removing for each iteration step i, with i ranging from 1 to p, uncured barrier material Iᵢ.

The number of iteration steps p is in principle not limited. The number of iteration steps p is for example 2, 3, 4 , 5 or 6.

It is clear that a lid L may comprise one lid deposit of cured barrier material I or a plurality of lid deposits of cured barrier material I for example deposited next to and/or on top of each other.

A lid deposit of cured barrier material may contact core material applied in step b. and/or - for an iteration step i higher than 1 - may contact barrier material obtained in a previous iteration step of c. A lid deposit of cured barrier material may also contact (partially or fully) the substrate.

As mentioned above, for each pocket the lid L covers the top of the core material as well as the lateral edges of the core material deposited on the base B of this pocket so that the cored material deposited on base B is fully encapsulated by a combination of the barrier material of the base B and the barrier material of the lid L.

By iterating step c. as described above, a high variety of lids L and/or a high variety of combinations of lids L can be obtained. It is for example possible to provide a plurality of lids L whereby the lids L may comprise the same barrier material or whereby the lids L or some of the lids L may comprise a different barrier material. It is for example possible to provide a first type of lid L comprising a first barrier material, a second type of lid L comprising a second barrier material and optionally one or more further types of lids L comprising a further barrier material. Furthermore, it is possible to provide a lid L or a plurality of lids L whereby each lid L comprises one type of barrier material or comprises different types of barrier materials. A lid L may for example comprise a first layer comprising a first barrier material, a second layer comprising a second barrier material and optional one or more further layers comprising a further barrier material. Additionally, a lid L may comprise deposits of cured barrier material next to each other. Such deposits may comprise the same barrier material or may comprise different barrier materials. A lid L may for example comprise deposits of cured first barrier material, deposits of cured second barrier material and optionally deposits of cured further barrier material together forming one lid L.

It is clear that the method to prepare one or more pockets of encapsulated material according to the present invention may comprise a number of iteration steps a1 to a3 to form one or more bases B and/or a number of iteration steps b1 to b3 to form core material on top of a base B and/or one or more iteration steps c1 to c3 to form one or more lids L of barrier material on the substrate provided with the one or more base(s) B. Similarly, the method to prepare one or more pockets of encapsulated material according to the present invention may comprise a number of iteration steps a1' to a3' to form one or more bases B and/or a number of iteration steps b1' to b3' to form core material on top of a base B and/or one or more iteration steps c1' to c3' to form one or more lids L of barrier material on the substrate provided with the one or more base(s) B.

In a particular method according to the present invention the substrate is provided with a release layer, for example a heat release layer, and the at least one pocket of encapsulated material is applied on the substrate provided with the release layer in such a way that the at least one pocket of encapsulated material is contacting the release layer. Alternatively, the method comprises the application of a release layer, for example a heat release layer, before the application of the at least one pocket of encapsulated material, in particular before forming one or more bases B on the substrate.

The presence of a release layer may facilitate the release of the pockets of encapsulated material. In case the release layer comprises a heat release layer, the pockets of encapsulated material can be released from the substrate by applying heat, for example by locally applying heat.

The method according to the present invention may comprise one or more additional steps. The method comprises for example an additional step of applying a first intermediate layer on top of one or more bases B between step a. and step b. of the method according to the present invention. Alternatively or additionally, the method may comprise an additional step of applying a second intermediate layer on the core material c between step b. and step c. of the method according to the present invention.

The first and/or second intermediate layer may for example act as a gas diffusion barrier layer.

The first and/or second intermediate layer can be applied by any technique known in the art such as by dipping, extrusion, doctor blading, jetting and roll-to-roll application techniques or by atomic layer deposition. A preferred technique to apply a first and/or a second intermediate layer comprises atomic layer deposition.

The first and/or second intermediate layer comprise for example an oxide layer as for example SiO₂, TiO₂ or Al₂O₃.

The method according to the present invention is in particular suitable to manufacture an array of pockets comprising encapsulated material, in particular an array of pockets comprising encapsulated photoemissive particles or photoemissive compounds such as quantum dots. The method according to the present invention has the advantage that it allows to prepare any type of array of pockets, either identical pockets or different pockets. The method allows to choose the number of pockets as well as the position of the pocket or pockets. Furthermore the method according to the present invention allows to select one or more pockets for individual pick up and/or transfer as described further in this application.

According to a second aspect of the present invention a pocket of encapsulated material or a plurality of pockets of encapsulated material is provided. The plurality of pockets of encapsulated material is for example arranged to form an array of pockets of encapsulated material.

The pockets of encapsulated material or the array of pockets of encapsulated material are preferably obtained by the above-described method to prepare pockets of encapsulated material.

The core material of the pockets of encapsulated material comprises for example quantum dots.

It is clear that a plurality of pockets or an array of pockets may comprise identical pockets or different pockets. An array of pockets comprises for examples pockets having different types of core material, for example comprising different types of quantum dots.

According to a third aspect of the present invention a device comprising a pocket of encapsulated material or a plurality of pockets of encapsulated material, for example an array of pockets comprising encapsulated material is provided.

Preferred devices comprise a pocket of encapsulated material comprising quantum dots or a plurality of pockets of encapsulated material comprising quantum dots, for example an array of pockets comprising encapsulated material comprising quantum dots.

Examples of such devices comprise devices in which the pockets of encapsulated material, for example the pockets comprising quantum dots, are illuminated by a primary light source, such as a blue LED, to create a tailored emission spectrum. Examples of such tailored emission spectra include, but or not limited to, white light with high color rendering index, separate narrow blue, green and red lines, or single narrow lines. Such light sources can be used for, but are not limited to, indoor lighting, display or projection applications.

According to a fourth aspect of the present invention a process to transfer a pocket of encapsulated material or an array of pockets of encapsulated material from a substrate to another substrate is provided. The method comprises the steps of
- providing a structure comprising a first substrate provided with pockets of encapsulated material obtained by the method defined above;
- transferring the pockets of encapsulated material to a second substrate.

In preferred embodiment, the structure comprising the first substrate provided with pockets of encapsulated material comprises a release layer, for example a heat release layer between the first substrate and the pockets of encapsulated material.

In a preferred method the structure comprising the first substrate provided with pockets of encapsulated material is brought in contact with a second substrate to transfer the pockets of encapsulated material from the first substrate to the second substrate. Subsequently, the pockets of encapsulated material are released from the first substrate and transferred to the second substrate. Optionally, an adhesion promoting layer is used to adhere the pockets of encapsulated material to the second substrate.

An alternative method to transfer the pockets of encapsulated material from a first substrate to a second substrate comprises a laser induced forward transfer method.

To form light sources, this transfer can lead to the direct deposition of a pocket or a plurality of pockets on a LED chip, for example a blue LED strip, providing the primary light, to the deposition of a pocket or a plurality of pockets on a light guide illuminated by the primary light source or to the deposition of a pocket or a plurality of pockets on any structure that couples the primary light into the pocket or the plurality of pockets.

A further method to transfer pockets of encapsulated material from a first substrate to a second substrate comprises micro-transfer-printing, using an elastomer stamp to transfer the pockets of encapsulated material from the first substrate to the second substrate.

### Brief description of the drawings

The present invention will be discussed in more detail below, with reference to the attached drawings, in which:
- Fig. 1 illustrates the method to prepare pockets of encapsulated material according to the present invention;
- Fig. 2 illustrates a pocket comprising encapsulated material according to the present invention;
- Fig. 3, Fig. 4 and Fig. 5 illustrate different embodiments of pockets comprising encapsulated material whereby the base B, the core material and/or the lid L of the pockets comprise respectively different deposits of cured barrier material b, different deposits of cured core material c and different deposits of cured barrier material I;
- Fig. 6 shows the transfer of pockets of encapsulated material from a first substrate to a second substrate.

### Description of embodiments

The present invention will be described with respect to particular embodiments and with reference to certain drawings but the invention is not limited thereto but only by the claims. The drawings are only schematic and are non-limiting. The size of some of the elements in the drawing may be exaggerated and not drawn on scale for illustrative purposes. The dimensions and the relative dimensions do not correspond to actual reductions to practice of the invention.

When referring to the endpoints of a range, the endpoints values of the range are included.

When describing the invention, the terms used are construed in accordance with the following definitions, unless indicated otherwise.

The term 'and/or' when listing two or more items, means that any one of the listed items can by employed by itself or that any combination of two or more of the listed items can be employed.

The term quantum dot refers to nanoscale crystals that can emit light of various colors when UV light hits these crystals. Such nanoscale crystals may have a homogeneous or substantially homogenous composition, for example a core or may have a heterogeneous composition as for example core/shell quantum dots comprising a core and a shell surrounding the core. The shell is defined as the material surrounding the core and may comprise one or more shell layers.

The core comprises for example a group III-V material, for example a binary, ternary or quaternary group III-V material for example comprising Ga and/or In as group III element and comprising N, P, As and/or Sb as group V element. Preferred core materials comprise InP, InAs, InSb, GaP, GaAs, GaSb, In(As,P), In(As,Sb), (In(P,Sb), (In,Ga)P, (In,Ga)As and (In,Ga)Sb. Furthermore, the core may comprise alloyed group II / group III materials in combination with group V pnictides, as for example (In,Zn)P.

The shell material comprises for example a group II-VI material, for example a binary, ternary or quaternary group II-VI material for example comprising Zn or Cd as group II(B) element and comprising O, S, Se and/or Te as group VI(A) element. Preferred shell materials comprise ZnSe, ZnS, ZnTe, ZnSSe, ZnCdSe and ZnSeTe.

Preferred examples of the core/shell quantum dots comprise InP/ZnSe quantum dots, InP/ZnS quantum dots, InP/ZnSe/ZnS quantum dots, InP/ZnS/ZnSe quantum dots, InP/XY whereby X comprises Cd, Zn and Y comprises S, Se, Te and combinations thereof as for example InP/CdₓZn₁₋ₓSe or InP/ZnTeₓSe₁₋ₓ.

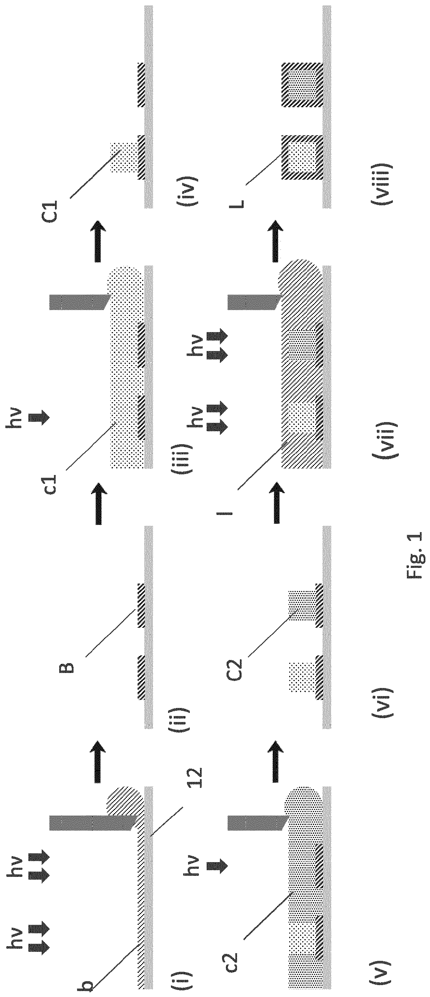

Figure 1 describes a method to prepare pockets of encapsulated material according to the present invention.

The first step (i) shows the application and light patterning of barrier material b. The barrier material comprises for example a photocurable acrylate resin optionally comprising clay platelets and/or cellulose nanofibrils, and is applied by doctor blading on substrate 12. The local curing is for example achieved by digital light processing. In step (ii) the uncured barrier is removed and bases B, spatially distinguished from each other, are formed on the substrate 12. In subsequent step (iii) a layer of a first type of core material c1 is applied and locally cured to form cured first type of core material on top of part of the bases B (step (iv)). The first core material c1 comprises for example a photocurable thiol-ene resin comprising green quantum dots and is for example applied by doctor blading. The local curing is for example achieved by digital light processing and results in the formation of cores C1. In step (v) a layer of a second type of core material c2 is applied and locally cured to form cured second type of core material c2 on top of another part of bases B (step (vi)). The second type of core material c2 comprises for example a photocurable thiol-ene resin comprising red quantum dots. Once cured, cores C2 are formed. Subsequently, in step (vii) barrier material I is applied and locally cured to form a lid L on the bases B provided with core material. The barrier material I to form the lid L comprises for example the same material as the barrier material b to form base B. The barrier material I comprises for example a photocurable acrylate resin optionally comprising clay platelets and/or cellulose nanofibrils, and is applied by doctor blading. The local curing is for example achieved by digital light processing. The curing is done in such a way to form a lid L of cured barrier material for each base B provided with core material c (for example first core material c1 or second core material c2) thus forming pockets (step (viii)). For each pocket the core material is fully encapsulated by the barrier material of the base B and the barrier material of the lid L.

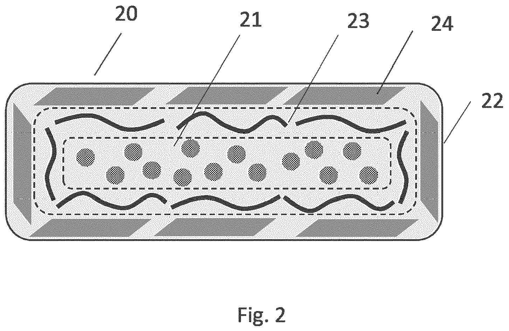

Figure 2 is an illustration of a pocket 20 of encapsulated material according to the present invention. The pocket 20 comprises core material 21 and an encapsulation 22 comprising barrier material. The core material 21 comprises for example a photocurable thiol-ene resin comprising quantum dots. The encapsulation 22 comprises for example one or more layers. In the embodiment shown in Fig. 2 the encapsulation 22 comprises a first layer 23 and a second layer 24. The first layer 23 comprises for example an oxygen barrier layer comprising cellulose nanofibrils and the second layer 24 comprises for example a water vapor barrier layer comprising clay platelets.

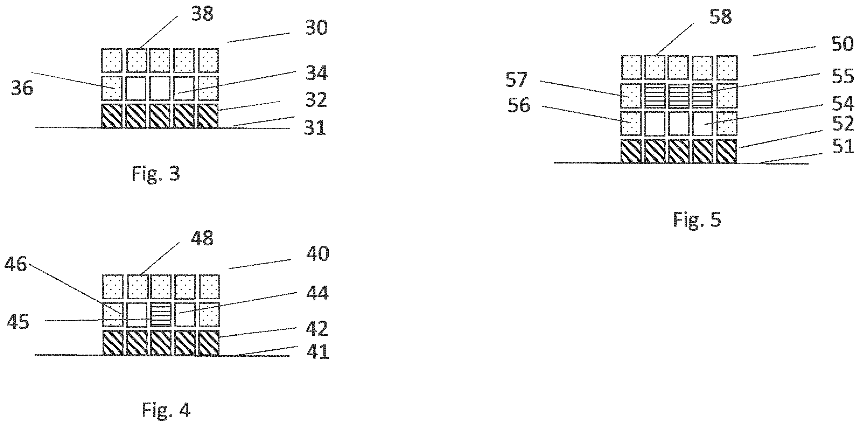

Fig. 3, Fig. 4 and Fig. 5 illustrate different embodiments of pockets comprising encapsulated material whereby the base B, the core material and/or the lid L comprise respectively one or more deposits of cured barrier material b, one or more deposits of cured core material c and one or more deposits of cured barrier material I. The base B, the core material and the lid L can be deposited in one step or can be deposited using a number of iteration steps.

The pocket 30 of Fig. 3 is obtained by first forming base B by applying barrier material b on a substrate 31 and by locally curing the barrier material b to form base deposits 32 of cured barrier material b next to each other. The different deposits 32 preferably contact each other. The distance created between different deposits shown in Figure 3 is only to illustrate the process. In reality, the different deposits contact each other. Once the base B is formed, the material to be encapsulated is applied on the base B by applying core material c on the substrate provided with the base B and by locally curing the core material to form base deposits 34 of cured core material. In a next step, a lid L is formed on top of a base B provided with core material to form the pocket 30. All cured core material deposited on one base B forms a core C. To form the lid L, barrier material I is applied on the substrate provided with the base B and the core material. This barrier material I is then locally cured to form deposits 36 of cured barrier material on top of the base B and next to the deposits 34 of cured core material so that the deposits 36 of cured barrier material I protect the lateral edges of the core material deposited on base B. Subsequently, barrier material I is applied on the thus obtained substrate. This barrier material I is locally cured to form deposits 38 of cured barrier material I covering the deposits 34 of cured core material c and the deposits 36 of cured barrier material I. In this way a lid L is obtained that is fully encapsulating the core material c. It is clear that the deposits 36 and 38 can also be obtained in one step.

The pocket 40 of Fig. 4 is obtained by first forming base B by applying and locally curing barrier material b to form deposits 42 of cured barrier material b on substrate 41 in a similar way as done in the embodiment shown in Fig. 3. Subsequently, the material to be encapsulated is applied on the base B by first applying and locally curing a first core material c1 to form deposits 44 of cured first core material c1 on the base B. In a next step, a second core material c2 is applied and locally cured to form deposits 45 of cured second material c2 on the base B. Then a lid L is formed by depositing deposits 46 and 48 of cured barrier material I in a similar way as the deposits 36 and 38 of the embodiment shown in Fig. 3. The deposits 44 of cured first core material c1 and the deposits of cured second core material c2 deposited on one base B form core C. Core C is fully encapsulated by the base B and the lid L, i.e. by deposits 42, deposits 46 and deposits 48.

The pocket 50 of Fig. 5 is obtained by first forming base B by applying and locally curing barrier material b to form deposits 52 of cured barrier material b on substrate 51 in a similar way as done in the embodiments shown in Fig. 3 and Fig. 4. Subsequently, a first layer of material to be encapsulated is applied on the base B by applying and locally curing a first core material c1 to form deposits 54 of cured first core material c1 on the base B. Then barrier material I is applied and locally cured to from deposits 56 of cured barrier material I on top of the base B and next to the deposits 54 of cured first core material c1 so that the deposits 56 of cured barrier material I protect the lateral edges of the first core material c1 deposited on base B. In a next step, a second layer of material to be encapsulated is applied on deposits 54 by applying and locally curing a second core material c2 to form deposits 55 of cured second core material c2 on top of deposits 54. Then barrier material I is applied an locally cured to form deposits 57 and 58 of cured barrier material I in a similar way as the deposits 36 and 38 of the embodiment shown in Fig. 3 and as the deposits 46 and 48 of the embodiment shown in Fig. 4.

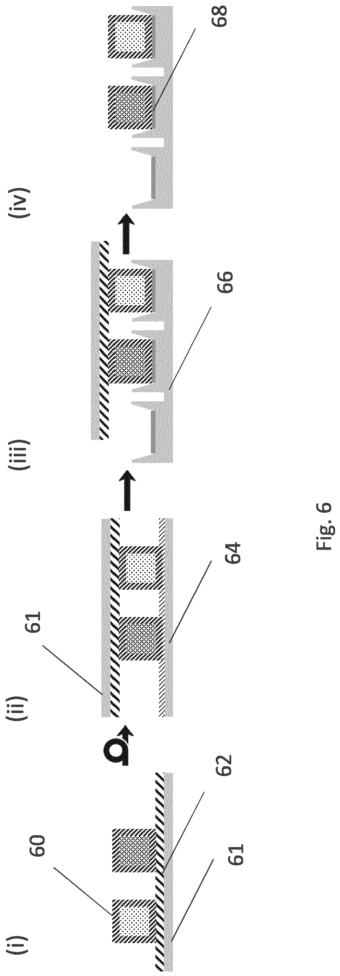

Fig. 6 shows the transfer of pockets 60 of encapsulated material from one substrate to another substrate. Fig. 6 (i) shows pockets 60 of encapsulated materials formed on a substrate 61 provided with a release layer 62, for example a heat release layer. The substrate 61 provided with the pockets 60 of encapsulated material is then turned upside down and lightly stamped on a thin layer of uncured resin 64 as shown in Fig. 6 (ii). Subsequently, the substrate 61 with the pockets 60 of encapsulated material is placed on top of a LED array 66, for example a blue LED array, as shown in Fig. 6 (iii). Each pocket 60 is thereby contacting a LED. Finally, the substrate 61 is removed, for example by applying heat to remove the heat release layer 62 (Fig. 6 (iv)).

In a preferred method the LEDs are lightened up to generate locate heating so that the thin layer 68 of resin applied on the pockets 60 of encapsulated material can cure thus ensuring adhesion of the pockets 60 to the LEDs and/or to release the pockets 60 from the substrate 61.

## Claims

1. A method to prepare at least one pocket comprising encapsulated material, the pocket comprises a core of core material surrounded by an encapsulation of barrier material, the method comprising the steps of
a. forming one or more bases B of barrier material on a substrate by
a1. applying barrier material b on the substrate, the barrier material b comprising a resin;
a2. locally curing the barrier material b to form one base B or a plurality of bases B of cured barrier material b, each base B being spatially distinguished from another base B and each base B covering an area A_{B} of the substrate;
a3. removing uncured barrier material b;
b. forming core material c on top of at least part of the bases B by,
b1. applying core material c on the substrate obtained from step a., the core material c comprising a resin and at least one photoemissive particle or photoemissive compound;
b2. locally curing the core material c to form one core deposit or a plurality of core deposits of cured core material c, with each core deposit of cured core material c being deposited on top of a base B and none of said core deposits of cured core material c extending beyond the area A_{B};
b3. removing uncured core material c;
c. forming one or more lids L of barrier material on the substrate provided with the one or more bases B and provided with the core material by
c1. applying barrier material I on the substrate obtained from step b., the barrier material I comprising a resin;
c2. locally curing the barrier material I to form a lid L of cured barrier material I on top of each base B provided with core material c, each lid L being spatially distinguished from another lid L, each base B provided with core material c and the lid L formed on top of this base B forming a pocket, whereby said pocket is fully encapsulating the core material c provided on the base B of said pocket.
c3. removing uncured barrier material I.

2. The method according to claim 1 wherein step a. comprises n iterations of steps a1' to a3', with n being at least 2 and with a1' to a3' being
a1'. applying for each iteration step i, with i ranging from 1 to n, a layer of barrier material bᵢ on the substrate or on the substrate provided with barrier material obtained from a previous iteration step of step a., whereby for each iteration step i higher than 1, the barrier material bᵢ comprises the same or a different barrier material than the barrier material used in a previous iteration step of step a.;
a2'. locally curing for each iteration step i, with i ranging from 1 to n, the barrier material bᵢ to form one base deposit or a plurality of base deposits of cured barrier material bᵢ, with each base deposit of cured barrier material bᵢ contacting the substrate or contacting a deposit of cured barrier material obtained in a previous iteration step of step a. to form after iteration step n a base B or a plurality of bases B, each base B being spatially distinguished from another base B and each base B covering an area A_{B} of the substrate;
a3'. removing for each iteration step i, with i ranging from 1 to n, uncured barrier material bᵢ.

3. The method according to claim 1 or claim 2 wherein step b. comprises m iterations of steps b1' to b3', with m being at least 2 and with b1' to b3' being
b1'. applying for each iteration step i, with i ranging from 1 to m, a layer of core material cᵢ on the substrate obtained from step a. or on the substrate obtained from a previous iteration step of step b., whereby for each iteration step i higher than 1 the core material cᵢ comprises the same or a different core material than the core material used in a previous iteration step of step b.;
b2'. locally curing for each iteration step i, with i ranging from 1 to m, the core material cᵢ to form one core deposit or a plurality of core deposits of cured core material cᵢ, with each core deposit of cured core material cᵢ contacting a base B or contacting a deposit of cured core material obtained in a previous iteration step of step b. and none of said core deposits of cured core material extending beyond the area Aₛ;
b3'. removing for each iteration step i , with i ranging from 1 to m, uncured core material Cᵢ.

4. The method according to any one of the preceding claims, wherein step c. comprises p iterations of steps c1' to c3', with p being at least 2 and with c1' to c3' being
c1'. applying for each iteration step i, with i ranging from 1 to p, a layer of barrier material Iᵢ on the substrate obtained from method step b. or on the substrate obtained from a previous iteration step of step c., whereby for each iteration step i higher than 1 the barrier material Iᵢ comprises the same or a different barrier material than the barrier material used in a previous iteration step of step c.;
c2'. locally curing for each iteration step i, with i ranging from 1 to p, the barrier material Iᵢ to form one lid deposit or a plurality of lid deposits of cured barrier material Iᵢ in such a way to form after iteration step p for each base B provided with core material a lid L, each lid L being spatially distinguished from another lid L, whereby each base B provided with core material c and the lid L provided on this base B form a pocket whereby all core material provided on this base B is fully encapsulated by a combination of the base B and the lid L of this pocket;
c3'. removing for each iteration step i , with i ranging from 1 to p, uncured barrier material Iᵢ.

5. The method according to any one of the preceding claims, wherein the curing of the barrier material and/or the curing of the core material comprises photocuring.

6. The method according to any one of the preceding claims, wherein the application and locally curing of the barrier material and/or of the core material comprises photolithography using a physical mask or digital light modulation for example digital light processing (DLP), laser-based stereolithography (SLA), liquid crystal display (LCD) masking, liquid crystal display (LCD) projecting or multiphoton lithography (for example two photon lithography (TPL)).

7. The method according to any one of the preceding claims, wherein the barrier material and/or the core material comprises a photocurable resin and optionally at least one photoinitiator and/or at least one filler and/or at least one dye.

8. The method according to any one of the preceding claims, wherein the barrier material of the base(s) B and the barrier material of the lid(s) L comprise the same material.

9. The method according to any one of the preceding claims, wherein the at least one photoemissive particle or photoemissive compound comprises quantum dots, organic dyes, inorganic phosphors, metal clusters, carbon dots, doped nanocrystals or combinations thereof.

10. The method according to any one of the preceding claims, wherein the substrate comprises a release layer or the method further comprises the step of applying a release layer on the substrate before applying the barrier material of the base B.

11. The method according to any one of the preceding claims, wherein the method comprises an additional step of applying a first intermediate layer on top of one or more bases B between step a. and step b. and/or an additional step of applying a second intermediate layer on the core material c between step b. and step c.

12. A method according to any one of the preceding claims to prepare an array of pockets comprising encapsulated material.

13. A pocket of encapsulated material or an array of pockets of encapsulated materials obtained by the method as defined in any one of claims 1 to 12.

14. A device comprising at least one pocket of encapsulated material or an array of pockets of encapsulated material as defined in claim 13.

15. A process to transfer a pocket of encapsulated material or an array of pockets of encapsulated material, the process comprising the steps of
- providing a structure comprising a first substrate provided with pockets of encapsulated material obtained by the method defined in any one of claims 1 to 12, the structure preferably comprising a release layer between the first substrate and the pockets of encapsulated material;
- transferring the pockets of encapsulated material to a second substrate.

## Patentansprüche

1. Verfahren zur Herstellung von mindestens einer Tasche, die verkapseltes Material umfasst, wobei die Tasche einen Kern aus Kernmaterial, umgeben von einer Verkapselung aus Barrierematerial, umfasst, wobei das Verfahren die Schritte umfasst:
a. Bilden von einer oder mehreren Basen B aus Barrierematerial auf einem Substrat durch
a1. Aufbringen von Barrierematerial b auf das Substrat, wobei das Barrierematerial b ein Harz umfasst;
a2. lokales Härten des Barrierematerials b, um eine Basis B oder eine Vielzahl von Basen B des gehärteten Barrierematerials b zu bilden, wobei jede Basis B räumlich von einer anderen Basis B verschieden ist und jede Basis B eine Fläche A_{B} des Substrats bedeckt;
a3. Entfernen von ungehärtetem Barrierematerial b;
b. Bilden von Kernmaterial c auf mindestens einem Teil der Basen B durch
b1. Aufbringen von Kernmaterial c auf das aus Schritt a. erhaltenen Substrat, wobei das Kernmaterial c ein Harz und mindestens ein photoemissives Partikel oder eine photoemissive Verbindung umfasst;
b2. lokales Härten des Kernmaterials c, um eine Kernabscheidung oder eine Vielzahl von Kernabscheidungen des gehärteten Kernmaterials c zu bilden, wobei jede Kernabscheidung des gehärteten Kernmaterials c auf einer Basis B abgeschieden wird und keine der Kernabscheidungen des gehärteten Kernmaterials c sich über die Fläche A_{B} hinaus erstreckt;
b3. Entfernen von ungehärtetem Kernmaterial c;
c. Bilden von einem oder mehreren Deckeln L aus Barrierematerial auf dem mit der einen oder den mehreren Basen B und mit Kernmaterial ausgestatteten Substrat durch c1. Aufbringen von Barrierematerial I auf das aus Schritt b. erhaltene Substrat, wobei das Barrierematerial I ein Harz umfasst;
c2. lokales Härten des Barrierematerials I, um einen Deckel L aus gehärtetem Barrierematerial I auf jeder Basis B zu bilden, die mit Kernmaterial c ausgestattet ist, wobei jeder Deckel L räumlich von einem anderen Deckel L verschieden ist, jede Basis B mit Kernmaterial c ausgestattet ist, und der Deckel L oben auf dieser Basis B gebildet ist, wodurch eine Tasche gebildet wird, wobei die Tasche das auf der Basis B der Tasche bereitgestellte Kernmaterial c vollständig verkapselt;
c3. Entfernen von ungehärtetem Barrierematerial I.

2. Verfahren nach Anspruch 1, wobei der Schritt a. n Iterationen der Schritte a1' bis a3' umfasst, wobei n mindestens 2 ist und a1' bis a3' wie folgt sind:
a1'. Aufbringen einer Schicht aus Barrierematerial bᵢ auf das Substrat oder auf das mit Barrierematerial ausgestattete Substrat, das aus einem vorhergehenden Iterationsschritt von Schritt a. erhalten wurde, für jeden Iterationsschritt i, wobei i im Bereich von 1 bis n liegt, wobei für jeden Iterationsschritt i höher als 1 das Barrierematerial bᵢ das gleiche oder ein anderes Barrierematerial als das Barrierematerial umfasst, das in einem vorhergehenden Iterationsschritt von Schritt a. verwendet wurde;
a2'. lokales Härten des Barrierematerials bᵢ, um eine Basisabscheidung oder eine Vielzahl von Basisabscheidungen aus gehärtetem Barrierematerial bᵢ zu bilden, für jeden Iterationsschritt i, wobei i im Bereich von 1 bis n liegt, wobei jede Basisabscheidung des gehärteten Barrierematerials bᵢ das Substrat kontaktiert oder eine Abscheidung aus gehärtetem Barrierematerial kontaktiert, die in einem vorhergehenden Iterationsschritt von Schritt a. erhalten wurde, um nach dem Iterationsschritt n eine Basis B oder eine Vielzahl von Basen B zu bilden, wobei jede Basis B räumlich von einer anderen Basis B verschieden ist und jede Basis B eine Fläche A_{B} des Substrats bedeckt;
a3'. Entfernen von ungehärtetem Barrierematerial bᵢ für jeden Iterationsschritt i, wobei i im Bereich von 1 bis n liegt.

3. Verfahren nach Anspruch 1 oder Anspruch 2, wobei Schritt b. m Iterationen der Schritte b1' bis b3' umfasst, wobei m mindestens 2 ist und b1' bis b3' wie folgt sind:
b₁'. Aufbringen einer Schicht aus Kernmaterial cᵢ auf das aus Schritt a. erhaltene Substrat oder auf aus das aus einem vorhergehenden Iterationsschritt von b. erhaltene Substrat, für jeden Iterationsschritt i, wobei i im Bereich von 1 bis m liegt, wobei für jeden Iterationsschritt i höher als 1 das Kernmaterial cᵢ das gleiche oder ein anderes Kernmaterial als das Kernmaterial umfasst, das in einem vorhergehenden Iterationsschritt von Schritt b. verwendet wurde;
b2'. lokales Härten des Kernmaterials cᵢ, um eine Kernabscheidung oder eine Vielzahl von Kernabscheidungen aus gehärtetem Kernmaterial cᵢ zu bilden, für jeden Iterationsschritt i, wobei i im Bereich von 1 bis m liegt, wobei jede Kernabscheidung des gehärteten Kernmaterials cᵢ eine Basis B kontaktiert oder eine Abscheidung aus gehärtetem Kernmaterial kontaktiert, die in einem vorhergehenden Iterationsschritt von Schritt b. erhalten wurde, und keine der Kernablagerungen des gehärteten Kernmaterials sich über die Flächen Aₛ hinaus erstreckt;
b3'. Entfernen von ungehärtetem Kernmaterial cᵢ für jeden Iterationsschritt i, wobei i im Bereich von 1 bis m liegt.

4. Verfahren nach einem der vorhergehenden Ansprüche, wobei Schritt c. p Iterationen der Schritte c1' bis c3' umfasst, wobei p mindestens 2 ist und c1' bis c3' wie folgt sind:
c1'. Aufbringen einer Schicht aus Barrierematerial Iᵢ auf das aus Verfahrensschritt b. erhaltene Substrat oder auf das aus einem vorhergehenden Iterationsschritt von Schritt c. erhaltene Substrat, für jeden Iterationsschritt i, wobei i im Bereich von 1 bis p liegt, wobei für jeden Iterationsschritt i höher als 1 das Barrierematerial Iᵢ das gleiche oder ein anderes Barrierematerial als das Barrierematerial umfasst, das in einem vorhergehenden Iterationsschritt von Schritt c. verwendet wurde;
c2'. lokales Härten des Barrierematerials Iᵢ, um eine Deckelabscheidung oder eine Vielzahl von Deckelabscheidungen aus gehärtetem Barrierematerial Iᵢ zu bilden, für jeden Iterationsschritt i, wobei i im Bereich von 1 bis p liegt, in einer solchen Weise, dass nach Iterationsschritt p für jede Basis B, die mit Kernmaterial ausgestattet ist, ein Deckel L gebildet wird, jeder Deckel L räumlich von einem anderen Deckel L verschieden ist, wobei jede Basis B, die mit Kernmaterial c ausgestattet ist, und der auf dieser Basis B bereitgestellte Deckel L eine Tasche bilden, wobei alles auf dieser Basis B bereitgestellte Kernmaterial durch eine Kombination aus der Basis B und dem Deckel L dieser Tasche vollständig verkapselt ist;
c3'. Entfernen von ungehärtetem Barrierematerial Iᵢ für jeden Iterationsschritt i, wobei i im Bereich von 1 bis p liegt.

5. Verfahren nach einem der vorhergehenden Ansprüche, wobei das Härten des Barrierematerials und/oder das Härten des Kernmaterials Photohärten umfasst/umfassen.

6. Verfahren nach einem der vorhergehenden Ansprüche, wobei das Aufbringen und lokale Härten des Barrierematerials und/oder des Kernmaterials Photolithographie unter Verwendung einer physischen Maske oder digitaler Lichtmodulation umfassen, beispielsweise digitale Lichtverarbeitung (DLP), lasergestützte Stereolithographie (SLA), Flüssigkristallanzeigen- (LCD)-Maskierung, Flüssigkristallkristallanzeigen- (LCD)-Projektion oder Multiphotonenlithographie (beispielsweise Zwei-Photonen-Lithographie (TPL)).

7. Verfahren nach einem der vorhergehenden Ansprüche, wobei das Barrierematerial und/oder das Kernmaterial ein photohärtbares Harz und gegebenenfalls mindestens einen Photoinitiator und/oder mindestens einen Füllstoff und/oder mindestens einen Farbstoff umfasst/umfassen.

8. Verfahren nach einem der vorhergehenden Ansprüche, wobei das Barrierematerial der Basis/Basen B und das Barrierematerial des Deckels/der Deckel L das gleiche Material umfassen.

9. Verfahren nach einem der vorhergehenden Ansprüche, wobei das mindestens eine photoemissive Partikel oder die mindestens eine photoemissive Verbindung Quantenpunkte, organische Farbstoffe, anorganische Leuchtstoffe, Metallcluster, Kohlenstoffpunkte, dotierte Nanokristalle oder Kombinationen davon umfasst.

10. Verfahren nach einem der vorhergehenden Ansprüche, wobei das Substrat eine Trennschicht umfasst oder das Verfahren des Weiteren den Schritt des Aufbringens einer Trennschicht auf das Substrat vor dem Aufbringen des Barrierematerials der Basis B umfasst.

11. Verfahren nach einem der vorhergehenden Ansprüche, wobei das Verfahren einen zusätzlichen Schritt des Aufbringens einer ersten Zwischenschicht auf eine oder mehrere Basen B zwischen Schritt a. und Schritt b. umfasst, und/oder einen zusätzlichen Schritt des Aufbringens einer zweiten Zwischenschicht auf das Kernmaterial c zwischen Schritt b. und Schritt c. umfasst.

12. Verfahren nach einem der vorhergehenden Ansprüche zur Herstellung einer Gruppierung von Taschen, die verkapseltes Material umfassen.

13. Tasche aus verkapseltem Material oder Gruppierung von Taschen aus verkapselten Materialien, erhalten nach dem Verfahren wie in einem der Ansprüche 1 bis 12 definiert.

14. Vorrichtung, umfassend mindestens eine Tasche aus verkapseltem Material oder eine Gruppierung von Taschen aus verkapseltem Material, wie in Anspruch 13 definiert.

15. Verfahren zum Transferieren einer Tasche aus verkapseltem Material oder einer Gruppierung von Taschen aus verkapseltem Material, wobei das Verfahren die Schritte umfasst:
- Bereitstellen einer Struktur, umfassend ein erstes Substrat, das mit Taschen aus verkapseltem Material ausgestattet ist, die nach dem Verfahren erhalten werden, das in einem der Ansprüche 1 bis 12 definiert ist, wobei die Struktur vorzugsweise eine Trennschicht zwischen dem ersten Substrat und den Taschen aus verkapseltem Material umfasst;
- Transferieren der Taschen aus verkapseltem Material auf ein zweites Substrat.

## Revendications

1. Procédé destiné à préparer au moins une poche comprenant un matériau encapsulé, la poche comprenant un cœur de matériau de cœur entouré par une encapsulation de matériau barrière, le procédé comprenant les étapes suivantes :
a. formation d'une ou plusieurs bases B de matériau barrière sur un substrat par
a1. application de matériau barrière b sur le substrat, le matériau barrière b comprenant une résine ;
**a2.** durcissement local du matériau barrière b pour former une base B ou une pluralité de bases B de matériau barrière b durci, chaque base B étant différenciée spatialement d'une autre base B et chaque base B recouvrant une aire A_{B} du substrat ;
a3. retrait du matériau barrière b non durci ;
b. formation d'un matériau de cœur c au-dessus d'au moins une partie des bases B par
b1. application de matériau de cœur c sur le substrat obtenu à partir de l'étape a., le matériau de cœur c comprenant une résine et au moins une particule photoémissive ou composé photoémissif ;
b2. durcissement local du matériau de cœur c pour former un dépôt de cœur ou une pluralité de dépôts de cœur de matériau de cœur c durci, chaque dépôt de cœur de matériau de cœur c durci étant déposé au-dessus d'une base B et aucun desdits dépôts de cœur de matériau de cœur c durci ne s'étendant au-delà de l'aire A_{B} ;
b3. retrait du matériau de cœur c non durci ;
c. formation d'un ou plusieurs couvercles L de matériau barrière sur le substrat pourvu de la ou des bases B et pourvu du matériau de cœur par
c1. application de matériau barrière I sur le substrat obtenu à partir de l'étape b., le matériau barrière I comprenant une résine ;
c2. durcissement local du matériau barrière I pour former un couvercle L de matériau barrière I durci au-dessus de chaque base B pourvue de matériau de cœur c, chaque couvercle L étant différencié spatialement d'un autre couvercle L, chaque base B pourvue de matériau de cœur c et le couvercle L formé au-dessus de cette base B formant une poche, moyennant quoi ladite poche encapsule entièrement le matériau de cœur c disposé sur la base B de ladite poche ;
c3. retrait du matériau barrière I non durci.

2. Procédé selon la revendication 1 dans lequel l'étape a. comprend n itérations d'étapes a1' à a3', n valant au moins 2 et a1' à a3' étant
a1'. l'application, pour chaque étape d'itération i, i allant de 1 à n, d'une couche de matériau barrière bᵢ sur le substrat ou sur le substrat pourvu de matériau barrière obtenu à partir d'une étape d'itération précédente de l'étape a., moyennant quoi, pour chaque étape d'itération i supérieure à 1, le matériau barrière bᵢ comprend un matériau barrière identique ou différent du matériau barrière utilisé dans une étape d'itération précédente de l'étape a. ;
a2'. le durcissement local, pour chaque étape d'itération i, i allant de 1 à n, du matériau barrière bᵢ pour former un dépôt de base ou une pluralité de dépôts de base de matériau barrière bᵢ durci, chaque dépôt de base de matériau barrière bᵢ durci étant en contact avec le substrat ou en contact avec un dépôt de matériau barrière durci obtenu dans une étape d'itération précédente de l'étape a. pour former, après l'étape d'itération n, une base B ou une pluralité de bases B, chaque base B étant différenciée spatialement d'une autre base B et chaque base B recouvrant une aire A_{B} du substrat ;
a3'. le retrait, pour chaque étape d'itération i, i allant de 1 à n, du matériau barrière bᵢ non durci.

3. Procédé selon la revendication 1 ou la revendication 2 dans lequel l'étape b. comprend m itérations d'étapes b1' à b3', m valant au moins 2 et b1' à b3' étant
b1'. l'application, pour chaque étape d'itération i, i allant de 1 à m, d'une couche de matériau de cœur cᵢ sur le substrat obtenu à partir de l'étape a. ou sur le substrat obtenu à partir d'une étape d'itération précédente de l'étape b., moyennant quoi, pour chaque étape d'itération i supérieure à 1, le matériau de cœur cᵢ comprend un matériau de cœur identique ou différent du matériau de cœur utilisé dans une étape d'itération précédente de l'étape b. ;
b2'. le durcissement local, pour chaque étape d'itération i, i allant de 1 à m, du matériau de cœur cᵢ pour former un dépôt de cœur ou une pluralité de dépôts de cœur de matériau de cœur cᵢ durci, chaque dépôt de cœur de matériau de cœur cᵢ durci étant en contact avec une base B ou en contact avec un dépôt de matériau de cœur durci obtenu dans une étape d'itération précédente de l'étape b., et aucun desdits dépôts de cœur de matériau de cœur durci ne s'étendant au-delà de l'aire A_{S} ;
b3'. le retrait, pour chaque étape d'itération i, i allant de 1 à m, du matériau de cœur cᵢ non durci.

4. Procédé selon l'une quelconque des revendications précédentes, dans lequel l'étape c. comprend p itérations d'étapes c1' à c3', p valant au moins 2 et c1' à c3' étant
c1'. l'application, pour chaque étape d'itération i, i allant de 1 à p, d'une couche de matériau barrière Iᵢ sur le substrat obtenu à partir de l'état de procédé b. ou sur le substrat obtenu à partir d'une étape d'itération précédente de l'étape c., moyennant quoi, pour chaque étape d'itération i supérieure à 1, le matériau barrière Iᵢ comprend un matériau barrière identique ou différent du matériau barrière utilisé dans une étape d'itération précédente de l'étape c. **;**
c2'**.** le durcissement local, pour chaque étape d'itération i, i allant de 1 à p, du matériau barrière Iᵢ pour former un dépôt de couvercle ou une pluralité de dépôts de couvercle de matériau barrière Iᵢ durci de manière à former, après l'étape d'itération p, pour chaque base B pourvue de matériau de cœur, un couvercle L, chaque couvercle L étant différencié spatialement d'un autre couvercle L, moyennant quoi chaque base B pourvue de matériau de cœur c et le couvercle L disposé sur cette base B forment une poche, moyennant quoi tout le matériau de cœur disposé sur cette base B est entièrement encapsulé par une combinaison de la base B et du couvercle L de cette poche ;
c3'. le retrait, pour chaque étape d'itération i, i allant de 1 à p, du matériau barrière Iᵢ non durci.

5. Procédé selon l'une quelconque des revendications précédentes, dans lequel le durcissement du matériau barrière et/ou le durcissement du matériau de cœur comprennent un photodurcissement.

6. Procédé selon l'une quelconque des revendications précédentes, dans lequel l'application et le durcissement local du matériau barrière et/ou du matériau de cœur comprennent une photolithographie utilisant un masque physique ou une modulation numérique de la lumière, par exemple un traitement numérique de la lumière (DLP), une stéréolithographie laser (SLA), un masquage d'écran à cristaux liquides (LCD), une projection d'écran à cristaux liquides (LCD) ou une lithographie multiphotonique (par exemple une lithographie biphotonique (TPL)).

7. Procédé selon l'une quelconque des revendications précédentes, dans lequel le matériau barrière et/ou le matériau de cœur comprennent une résine photodurcissable et éventuellement au moins un photoinitiateur et/ou au moins une charge et/ou au moins un colorant.

8. Procédé selon l'une quelconque des revendications précédentes, dans lequel le matériau barrière de la/des base(s) B et le matériau barrière du/des couvercle(s) L comprennent le même matériau.

9. Procédé selon l'une quelconque des revendications précédentes, dans lequel l'au moins une particule photoémissive ou composé photoémissif comprend des boîtes quantiques, des colorants organiques, des luminophores inorganiques, des amas métalliques, des boîtes quantiques de carbone, des nanocristaux dopés ou des combinaisons de ceux-ci.

10. Procédé selon l'une quelconque des revendications précédentes, le substrat comprenant une couche de décollement ou le procédé comprenant en outre l'étape d'application d'une couche de décollement sur le substrat avant l'application du matériau barrière de la base B.

11. Procédé selon l'une quelconque des revendications précédentes, le procédé comprenant une étape supplémentaire d'application d'une première couche intermédiaire au-dessus d'une ou plusieurs bases B entre l'étape a. et l'étape b. et/ou une étape supplémentaire d'application d'une deuxième couche intermédiaire sur le matériau de cœur c entre l'étape b. et l'étape c.

12. Procédé selon l'une quelconque des revendications précédentes destiné à préparer un réseau de poches comprenant un matériau encapsulé.

13. Poche de matériau encapsulé ou réseau de poches de matériaux encapsulés obtenus par le procédé tel que défini dans l'une quelconque des revendications 1 à 12.

14. Dispositif comprenant au moins une poche de matériau encapsulé ou un réseau de poches de matériau encapsulé tels que définis dans la revendication 13.

15. Procédé destiné à transférer une poche de matériau encapsulé ou un réseau de poches de matériau encapsulé, le procédé comprenant les étapes suivantes :
- fourniture d'une structure comprenant un premier substrat pourvu de poches de matériau encapsulé obtenue par le procédé défini dans l'une quelconque des revendications 1 à 12, la structure comprenant de préférence une couche de décollement entre le premier substrat et les poches de matériau encapsulé ;
- transfert des poches de matériau encapsulé à un deuxième substrat.
